# EUROPÄISCHE PATENTANMELDUNG

(11) **EP 2 562 104 A1**
(43) Veröffentlichungstag der Anmeldung: **27.02.2013**
(21) Anmeldenummer: 11006803.8
(22) Anmeldetag: 20.08.2011
(51) Int. Cl.: B65G 47/91, H01L 21/683

(54) **Unterdruck-Haltevorrichtung**

(71) Anmelder: Festo AG & Co. KG, 73734 Esslingen (DE)
(72) Erfinder: Gauchel, Wolfgang, Dr., 73730 Esslingen (DE); Zindl, Manfred, 72768 Reutlingen (DE)
(74) Vertreter: Abel, Martin

(57) **Zusammenfassung**

Es wird eine Unterdruck-Haltevorrichtung (1) vorgeschlagen, die einen Haltekopf (5) aufweist, in dem ein absaugbarer Absaughohlraum (16) ausgebildet ist, der mit einer Absaugöffnung (15) zu einer Arbeitsseite (8) ausmündet, wo sich eine um die Absaugöffnung (15) herum erstreckende ringförmige Haltefläche (23) befindet. Zwischen dieser Haltefläche (23) und einem festzuhaltenden Gegenstand (2) befindet sich ein Haltespalt (3), der beim Absaugen des Absaughohlraumes (16) von außen nach innen von Umgebungsluft durchströmt wird, so dass sich nach dem Bernoulli-Prinzip ein den Gegenstand (2) festhaltender Unterdruck einstellt.

## Beschreibung

Die Erfindung betrifft eine Unterdruck-Haltevorrichtung, mit mindestens einem Haltekopf, der mindestens eine in einer Hauptrichtung orientierte Arbeitsseite aufweist, an der er aufgrund eines durch Absaugen hervorrufbaren Unterdruckes einen Gegenstand festhalten kann, wobei der Haltekopf an der Arbeitsseite eine Absaugöffnung eines mit einer Unterdruckquelle verbundenen oder verbindbaren Absaughohlraumes aufweist und über eine die Absaugöffnung des Absaughohlraumes umschließende, im Betrieb gemeinsam mit dem festgehaltenen Gegenstand einen von angesaugter Umgebungsluft durchströmten und eine Spalthöhe (h) aufweisenden Ringspalt definierende ringförmige Stirnfläche verfügt.

Eine aus der DE 60125935 T2 bekannte Unterdruck-Haltevorrichtung dieser Art wird in der Halbleiterindustrie als Wafer-Spannfutter genutzt, um zu belichtende Wafer mit exakt planer Ausrichtung während des Belichtungsprozesses festzuhalten. Das Spannfutter enthält einen Haltekopf mit einer an einer Arbeitsseite angeordneten ringförmigen Wand, welche eine Ansaugkammer umschließt. In der Ansaugkammer sind Halterungsstifte angeordnet, die über eine ringförmige Stirnfläche der ringförmigen Wand vorstehen, so dass sich zwischen einem an den Haltestiften anliegenden Wafer und der ringförmigen Stirnfläche der ringförmigen Wand ein minimaler Spalt ergibt. Im Betrieb des Spannfutters wird die Ansaugkammer mit einem Unterdruck beaufschlagt, so dass der Wafer an die Haltestifte herangezogen und mittels des sich in der Ansaugkammer aufbauenden Unterdruckes festgehalten wird. Der minimale Ringspalt zwischen der ringförmigen Stirnfläche der ringförmigen Wand und des Wafers sorgt dafür, dass sich der Wafer an der ringförmigen Wand nicht abstützt und keiner unerwünschten Verformung ausgesetzt wird. Andererseits ist der Ringspalt so klein, dass er im Hinblick auf die Viskosität der Umgebungsluft die Luftströmung durch den Ringspalt auf ein Minimum reduziert und als "Vakuumdichtung" fungiert. Die typische Spalthöhe des Ringspaltes ist auf ein Maß zwischen 0,5 µm und 1,4 *µ*m begrenzt.

Im Hinblick auf den relativ großen Querschnitt der von der ringförmigen Wand umschlossenen Öffnung der Ansaugkammer werden bei der bekannten Unterdruck-Haltevorrichtung sehr viele Haltestifte benötigt, um den festzuhaltenden Wafer sicher abzustützen und an einer unerwünschten Verformung zu hindern. Dies bringt den Nachteil einer insgesamt sehr großen Kontaktfläche mit sich, woraus eine relativ hohe mechanische Beanspruchung des angesaugten Gegenstandes resultiert. Das bekannte Wafer-Spannfutter arbeitet quasi nach dem Prinzip eines Saugnapfes, wie er beispielsweise in der DE 20 2007 002 876 U1 beschrieben ist, wobei lediglich der randseitige Kontakt aufgrund des vorhandenen Ringspaltes vermieden wird.

Es sind auch bereits Sauggreifer bekannt, die ein berührungsfreies oder zumindest berührungsarmes Festhalten von Gegenständen ermöglichen. Solche Sauggreifer arbeiten nach dem Bernoulli-Prinzip und sind beispielsweise in der DE 10 2008 062 343 A1 offenbart. Bei derartigen Bernoulli-Sauggreifern wird Druckluft an einer Arbeitsseite eines Haltekopfes ausgeblasen, so dass sie zwischen einer ringförmigen Stirnfläche des Haltekopfes und dem festzuhaltenden Gegenstand hindurchströmt und bei diesem Hindurchströmen einen für das Festhalten verantwortlichen Unterdruck erzeugt. Ein konzeptioneller Nachteil dieser Art von Sauggreifern besteht allerdings in einem relativ hohen Luftverbrauch und mithin Energieverbrauch, in der Regel auch noch in Verbindung mit einer relativ hohen Geräuschemission im unmittelbaren Arbeitsbereich.

Der Erfindung liegt die Aufgabe zugrunde, eine Unterdruck-Haltevorrichtung zu schaffen, mit der sich Gegenstände schonend und dennoch mit geringem Energiebedarf festhalten lassen.

Zur Lösung dieser Aufgabe ist in Verbindung mit den eingangs genannten Merkmalen vorgesehen, dass die ringförmige Stirnfläche als Haltefläche ausgebildet ist, so dass der von ihr gemeinsam mit dem festzuhaltenden Gegenstand begrenzte Ringspalt einen ringförmigen Haltespalt bildet, in dem sich aufgrund der von außen nach innen hindurchströmenden Umgebungsluft nach dem Bernoulli-Prinzip ein zum Festhalten des Gegenstandes beitragender Unterdruck einstellt.

Auf diese Weise wird der zum Festhalten eines Gegenstandes erforderliche Unterdruck zwar nach dem bekannten Bernoulli-Prinzip erzeugt, verglichen mit bekannten Bernoulli-Sauggreifern jedoch nicht mittels ausgeblasener Druckluft, sondern auf der Grundlage einer mittels Unterdruck erzeugten Luftströmung. Die an den Absaughohlraum angelegte Unterdruckquelle ruft zwischen der an der Arbeitsseite angeordneten ringförmigen Stirnfläche und dem dieser Stirnfläche gegenüberliegenden Gegenstand eine von radial außen nach radial innen orientierte Luftströmung hervor, die nach dem Bernoulli-Prinzip in dem Ringspalt einen Unterdruck erzeugt, der zum Festhalten des Gegenstandes beiträgt. Im Hinblick darauf, dass die ringförmige Stirnfläche an der Erzeugung der Haltekraft beteiligt ist, kann sie als Haltefläche bezeichnet werden. Ebenso kann der Ringspalt aufgrund seiner Haltefunktion als Haltespalt bezeichnet werden. Anders als bei dem aus der DE 60125935 T2 bekannten Wafer-Spannfutter dient also der Ringspalt nicht zur Abdichtung, sondern hat eine Funktion zur aktiven Erzeugung einer Haltekraft. Verglichen mit konventionellen, auf der Basis von Überdruck arbeitenden Bernoulli-Sauggreifern hat die erfindungsgemäße Gestaltung unter anderem den Vorteil, dass der zum Erzeugen einer bestimmten Haltekraft erforderliche Luftverbrauch wesentlich geringer ist. Außerdem ergibt sich im Bereich der Arbeitsseite des Haltekopfes eine relativ geringe Geräuschemission.

Vorteilhafte Weiterbildungen der Erfindung gehen aus den Unteransprüchen hervor.

Die Unterdruck-Haltevorrichtung ist konstruktiv vorzugsweise so gestaltet, dass die an den Absaughohlraum angelegte Unterdruckquelle zwischen der an der Arbeitsseite angeordneten ringförmigen Stirnfläche und dem dieser Stirnfläche gegenüberliegenden Gegenstand eine von radial außen nach radial innen orientierte Luftströmung hervorruft, die in dem Ringspalt einen auf dem Bernoulli-Prinzip basierenden Unterdruck erzeugt, der maßgeblich für das Festhalten des Gegenstandes verantwortlich ist. Der zumindest überwiegende Anteil der erzeugten Haltekraft basiert hier also auf dem durch die durch den Haltespalt hindurchgesaugte Umgebungsluft erzeugten Unterdruck.

Um eine exakt definierte Relativlage zwischen dem Haltekopf und einem angesaugten Gegenstand zu erhalten, empfiehlt es sich, den Haltekopf im Bereich der Arbeitsseite mit Abstandshaltemitteln auszustatten, an denen sich der festzuhaltende Gegenstand abstützen kann. Diese Abstandshaltemittel definieren eine Gegenstands-Abstützebene, die der ringförmigen Haltefläche des Haltekopfes in der Hauptrichtung mit Abstand und insbesondere mit zu der Hauptrichtung rechtwinkeliger Ausrichtung vorgelagert ist. Die Abstandshaltemittel bewirken aufgrund der zwischen ihnen und dem daran anliegenden Gegenstand auftretenden Reibung außerdem auch eine Querstabilisierung des festzuhaltenden Gegenstandes.

Besonders effektiv arbeitet die Unterdruck-Haltevorrichtung, wenn die Spalthöhe (h) des zwischen der ringförmigen Haltefläche und dem Gegenstand beziehungsweise der Gegenstands-Abstützebene befindlichen Haltespaltes zwischen 0,05 mm und 0,2 mm liegt, wobei sich ein Abstand im Bereich zwischen 0,07 mm und 0,15 mm besonders empfiehlt. Die angegebenen Bereiche verstehen sich jeweils einschließlich der Bereichsgrenzen.

Die Spalthöhe (h) des Haltespaltes ist zweckmäßigerweise über die gesamte Ausdehnung des Haltespaltes hinweg zumindest im Wesentlichen konstant. Eventuell sich durch den Haltespalt hindurch erstreckende Bestandteile der Abstandshaltemittel sind hierbei außer Betracht.

Die ringförmige Haltefläche ist zweckmäßigerweise sowohl radial außen als auch radial innen kreisförmig konturiert. Zweckmäßigerweise hat die ringförmige Haltefläche einen dem halben Außendurchmesser entsprechenden Außenradius (Ra) und einen dem halben Innendurchmesser entsprechenden Innenradius (Ri), wobei das Radienverhältnis (Ra / Ri), also das Verhältnis zwischen dem Außenradius und dem Innenradius, zweckmäßigerweise im Bereich zwischen 0,3 und 0,8 und vorzugsweise im Bereich zwischen 0,5 und 0,7 liegt. Diese Bereichsangaben verstehen sich jeweils einschließlich der Bereichsgrenzen.

Im Betrieb der Unterdruck-Haltevorrichtung wird die radial außen umfangsseitig in den Haltespalt eingesaugte Umgebungsluft nach Hindurchströmen durch den Haltespalt in den Absaughohlraum eingesaugt und gelangt durch diesen hindurch zur angeschlossenen Unterdruckerzeugungseinrichtung. Wie sich gezeigt hat, ist es vorteilhaft, wenn die minimale Absaugquerschnittsfläche (As) des Absaughohlraumes nicht zu klein ist im Verhältnis zu der im Bereich des Außenradius (Ra) der Haltefläche definierten Eintrittsquerschnittsfläche (Ae) des Haltespaltes. Vorzugsweise ist die minimale Absaugquerschnittsfläche (As) mindestens so groß wie die genannte Eintrittsquerschnittsfläche (Ae), wobei sie insbesondere mindestens doppelt so groß ist wie die Eintrittsquerschnittsfläche (Ae) und zweckmäßigerweise das Dreifache bis Sechsfache der Eintrittsquerschnittsfläche (Aee) beträgt. Die genannten Flächen sind als im Betrieb von der angesaugten Umgebungsluft durchströmte Flächen beziehungsweise durchströmte Strömungsquerschnitte zu verstehen.

Der mit einer als Absaugöffnung bezeichneten Öffnung zur Arbeitsseite ausmündende Absaughohlraum ist in seiner Gestaltung prinzipiell beliebig. Besonders vorteilhaft wird angesehen, wenn der Absaughohlraum über eine zu der Arbeitsseite hin offene Absaugkammer verfügt und außerdem einen Absaugkanal enthält, der eine Verbindung zwischen der Absaugkammer und der zur Hervorrufung der Saugströmung genutzten Unterdruckquelle herstellt.

Die Absaugöffnung der Absaugkammer ist zweckmäßigerweise zentral an der Arbeitsseite des Haltekopfes angeordnet. Sie kann beispielsweise kreisförmig oder ringförmig gestaltet sein. Eine bevorzugte Ausgestaltung der Absaugkammer sieht einen zumindest partiell ringförmigen Querschnitt vor, wobei sich dieser ringförmige Querschnitt insbesondere dadurch ergibt, dass der Haltekopf einen zentral angeordneten Kernabschnitt aufweist, um den herum sich mit radialem Abstand ein als Hüllabschnitt bezeichenbarer äußerer Abschnitt des Haltekopfes herum erstreckt.

Zweckmäßigerweise ist die Unterdruck-Haltevorrichtung mit einer den für den Betrieb erforderlichen Luftstrom erzeugenden Unterdruckerzeugungseinrichtung ausgestattet. Diese Unterdruckerzeugungseinrichtung kann gesondert bezüglich des Haltekopfes vorgesehen oder als Baueinheit mit dem Haltekopf ausgebildet sein. Als externe, gesonderte Unterdruckerzeugungseinrichtung empfiehlt sich eine Vakuumpumpe. Bei einer integrierten Lösung ist vor allem eine nach dem Grundprinzip einer Strahlpumpe arbeitende Ejektoreinrichtung aufgrund ihrer kompakten Abmessungen sehr vorteilhaft. Diese Ejektoreinrichtung wird mit Druckluft betrieben und verfügt über einen Absauganschluss, der an den Absaughohlraum angeschlossen oder anschließbar ist. Die Ejektoreinrichtung ist zweckmäßigerweise direkt an den Haltekopf angesetzt. Sie kann auch unmittelbar in den Haltekopf oder einen Kopfkörper dieses Haltekopfes integriert sein.

Insbesondere der Haltekopf der Unterdruck-Haltevorrichtung kann zumindest partirll als generativ gefertigtes einstückiges Bauteil ausgebildet sein. Auf diese Weise lassen sich alle relevanten Strukturen mit hoher Präzision und dennoch sehr kostengünstig herstellen. Der Begriff "generative Fertigungsverfahren" bezeichnet im Allgemeinen die häufig auch als Rapid Prototyping beziehungsweise Rapid Manufacturing bezeichneten Verfahren zur schnellen und kostengünstigen Fertigung von Produkten. Die Fertigung erfolgt dabei direkt auf der Basis rechnerinterner Datenmodelle, insbesondere aus formlosen Pulvern mittels chemischer und/oder physikalischer Prozesse. Obwohl es sich hierbei um urformende Verfahren handelt, sind für die Realisierung des konkreten Erzeugnisses keine speziellen Werkzeuge erforderlich, in denen die Geometrie des herzustellenden Produktes implementiert ist, wie beispielsweise Gussformen. Bei der Unterdruck-Haltevorrichtung können mittels der generativen Fertigung insbesondere optimale Strömungsgeometrien innerhalb des Absaughohlraumes hergestellt werden. Anstelle scharfer Kanten, die möglicherweise ungünstige Strömungsabrisse zur Folge haben, lassen sich strömungsgünstige, abgerundete Konturen realisieren.

Unter verschiedenen bekannten Verfahren der generativen Fertigung eignet sich vor allem das sogenannte selektive Lasersintern zur Herstellung des integralen Haltekopfes. Beim selektiven Lasersintern handelt es sich um ein Verfahren, bei dem räumliche Strukturen durch Sintern aus einem pulverförmigen Ausgangsstoff hergestellt werden. Die DE 10 2006 022 855 A1 offenbart bereits eine Greifervorrichtung, die über einen einstückig unter Verwendung eines generativen Fertigungsverfahrens hergestellten Greifkörper verfügt.

Die Unterdruck-Haltevorrichtung ist für verschiedenste Zwecke nutzbar. Sie eignet sich beispielsweise zum Festhalten eines Gegenstandes während seiner Bearbeitung. Als besonders vorteilhaft wird eine Ausgestaltung als Greifvorrichtung angesehen, die man auch als Sauggreifer bezeichnen könnte und die genutzt werden kann, um einen Gegenstand aufgrund des erzeugten Unterdruckes zu ergreifen und anschließend durch beliebige Bewegungen nach Bedarf umzupositionieren. Solche Anwendungen finden sich vor allem in der Fertigungs- und Montagetechnik.

Nachfolgend wird die Erfindung anhand der beiliegenden Zeichnung näher erläutert. In dieser zeigen:
- Figur 1: eine bevorzugte erste Ausführungsform der erfindungsgemäßen Unterdruck-Haltevorrichtung in einem Längsschnitt gemäß Schnittlinie I-I aus Figur 3 in Verbindung mit einer schematisch angedeuteten Unterdruckerzeugungseinrichtung,
- Figur 2: eine alternative Bauform der erfindungsgemäßen Unterdruck-Haltevorrichtung, wiederum im Längsschnitt, und
- Figur 3: eine Unteransicht mit Blick auf die Arbeitsseite der in Figur 1 illustrierten Unterdruck-Haltevorrichtung.

Die im Folgenden vereinfacht nur als "Haltevorrichtung" bezeichnete Unterdruck-Haltevorrichtung 1 eignet sich zum Festhalten eines schematisch angedeuteten und insbesondere plattenförmig ausgebildeten Gegenstandes 2 mittels eines in einem ringförmigen Haltespalt 3 unter Ausnutzung des sogenannten Bernoulli-Prinzips generierten Unterdruckes.

Die Haltevorrichtung 1 ist mit mindestens einem für die Erzeugung des Unterdruckes mit verantwortlichen Haltekopf 5 ausgestattet. Die Haltevorrichtung 1 kann über nur einen einzigen oder auch über mehrere solcher Halteköpfe 5 verfügen.

Der Haltekopf weist an geeigneter Stelle nicht weiter abgebildete Befestigungsmittel auf, beispielsweise Befestigungslöcher, mit deren Hilfe er beispielsweise mit einer Handhabungseinrichtung koppelbar ist, die seine bedarfsgemäße Positionierung und Verlagerung bewirken kann. Letzteres ist von Vorteil, wenn die Haltevorrichtung 1 als Greifvorrichtung beziehungsweise als Sauggreifer eingesetzt werden soll, um Gegenstände zu ergreifen und zwischen unterschiedlichen Positionen umzusetzen. Die weitere Beschreibung orientiert sich an einer derartigen Anwendung der Haltevorrichtung 1, wobei allerdings darauf hinzuweisen ist, dass sich die Haltevorrichtung 1 ohne weiteres auch als rein stationäre Vorrichtung zum zeitweiligen Festhalten eines Gegenstandes eignet, der beispielsweise einer Bearbeitung unterzogen werden soll.

Der durch die Haltevorrichtung 1 festzuhaltende Gegenstand wird bei der in der Zeichnung illustrierten Ausrichtung des Haltekopfes 5 unterhalb des Haltekopfes 5 platziert. Die dem festzuhaltenden Gegenstand 2 zugewandte Seite des Haltekopfes 5 - exemplarisch die Unterseite - sei im Folgenden als Arbeitsseite 8 bezeichnet.

Der Haltekopf 5 hat eine Hauptachse 7. Die Achsrichtung dieser Hauptachse 7 sei als Hauptrichtung bezeichnet. Bei einer typischen Anwendung der Haltevorrichtung 1 ist die Hauptachse 7 vertikal ausgerichtet. Die Arbeitsseite 8 ist in der Hauptrichtung orientiert. Bei der Hauptachse 7 handelt es sich insbesondere um eine Mittellängsachse des Haltekopfes 5.

Der Haltekopf 5 weist einen im Folgenden als Kopfkörper 13 bezeichneten Grundkörper auf. Dieser Kopfkörper 13 kann einteilig oder mehrteilig ausgebildet sein. Beim Ausführungsbeispiel ist er in vorteilhafter Weise einstückig ausgebildet. Hierbei ist er insbesondere unter Anwendung eines generativen Fertigungsverfahrens hergestellt. Zweckmäßig ist eine Fertigung durch sogenanntes selektives Lasersintern. Vor allem in diesem Zusammenhang besteht der Kopfkörper aus einem leichtgewichtigen Kunststoffmaterial. Besonders gut eignet sich dabei ein Polyamid-Kunststoff.

Der Haltekopf 5 enthält bei beiden Ausführungsbeispielen außer dem Kopfkörper 13 auch noch Abstandshaltemittel 14 für einen noch zu erläuternden Verwendungszweck. Die Abstandshaltemittel 14 sind zweckmäßigerweise als bezüglich des Kopfkörpers 13 separate und durch geeignete Maßnahmen an dem Kopfkörper 13 befestigte Komponenten ausgebildet und bestehen aus einem je nach Applikation individuell auswählbaren Werkstoff, beispielsweise aus sogenanntem POM, PEEK oder NBR. Es ist gleichwohl möglich, die Abstandshaltemittel und den Kopfkörper 13 einstückig auszubilden.

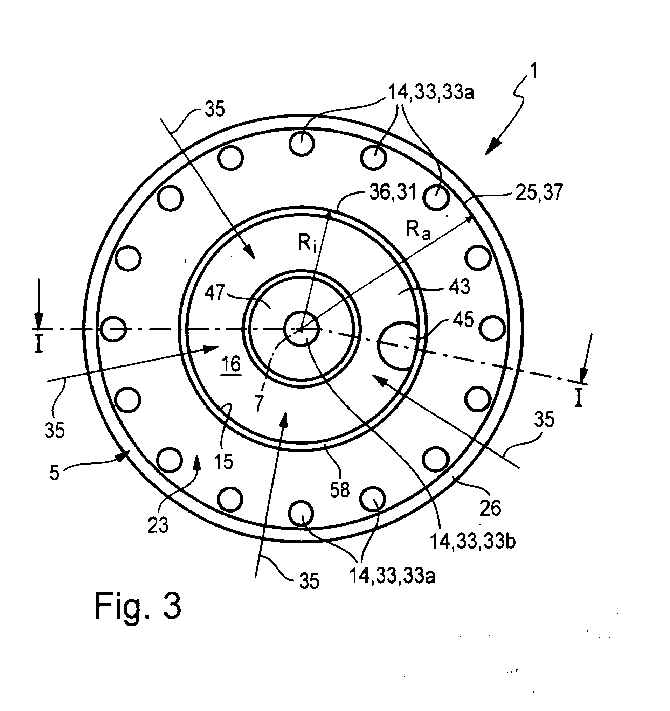

Der Haltekopf 5 beziehungsweise dessen Kopfkörper 13 hat vorzugsweise einen kreisförmigen Umriss, was in Figur 3 illustriert ist. Die Hauptachse 7 liegt bevorzugt im Zentrum dieses kreisförmigen Umrisses.

An der Arbeitsseite 8 weist der Kopfkörper 13 des Haltekopfes 5 mindestens eine und bevorzugt genau eine Öffnung 15 auf, die im Folgenden zur besseren Unterscheidung als Absaugöffnung 15 bezeichnet sei. Diese Absaugöffnung 15 ist bevorzugt mittig am Kopfkörper 13 platziert und hat vorzugsweise einen kreisförmigen Umriss.

Die Absaugöffnung 15 repräsentiert die Mündung eines im Innern des Haltekopfes 5 und insbesondere im Innern des Kopfkörpers 13 ausgebildeten Absaughohlraumes 16. Dieser Absaughohlraum 16 mündet abseits der Arbeitsseite 8 mit einer Anschlussöffnung 17 zu einer Außenfläche des Haltekopfes 4 aus. Vorzugsweise befindet sich die Mündung der Anschlussöffnung 17 an einer der Arbeitsseite 8 entgegengesetzten Rückseite 18 des Haltekopfes 5, sie kann jedoch auch ohne weiteres an einer quer dazu orientierten Seitenfläche 24 vorgesehen sein. Über die Anschlussöffnung 17 kann der Absaughohlraum 16 mit einer in der Zeichnung schematisch angedeuteten Unterdruckerzeugungseinrichtung 22 verbunden sein oder verbunden werden. Im Betrieb der Unterdruckerzeugungseinrichtung 22 wird somit der Absaughohlraum 16 abgesaugt und einem Unterdruck ausgesetzt.

Der Haltekopf 5 und exemplarisch der Kopfkörper 13 weisen an der Arbeitsseite 8 eine aufgrund ihrer Funktion im Folgenden als Haltefläche 23 bezeichnete ringförmige Stirnfläche auf. Diese ringförmige Haltefläche 23 ist in Achsrichtung der Hauptachse 7 orientiert und dem an der Arbeitsseite 8 angeordneten Gegenstand 2 zugewandt. Sie erstreckt sich rings um die Absaugöffnung 15 herum, die sie insbesondere konzentrisch umschließt.

Exemplarisch erstreckt sich die Haltefläche 23 in einer bezüglich der Hauptachse 7 rechtwinkeligen Radialebene. Je nach Anwendungsfall kann allerdings auch eine geringfügige Neigung vorgesehen sein, insbesondere derart, dass sie schräg nach radial außen und zugleich in Richtung zu dem Gegenstand 2 geneigt ist.

Die ringförmige Haltefläche 23 hat einen sie radial außen begrenzenden Außendurchmesser und einen sie radial innen begrenzenden Innendurchmesser. Der zum Außendurchmesser gehörende Außenradius ist in der Zeichnung mit Ra bezeichnet, der den Halbmesser des Innendurchmessers definierende Innenradius mit Ri. Das Zentrum der ringförmigen Haltefläche 23 liegt auf der Hauptachse 7.

Der Außenradius Ra kann auf dem Außendurchmesser des außen bevorzugt kreisförmig konturierten Kopfkörpers 13 liegen. Exemplarisch endet die Haltefläche 23 jedoch geringfügig radial innerhalb der radial nach außen orientierten Außenumfangsfläche 24 des Kopfkörpers 13. Der Übergangsbereich zwischen dem vom Außenradius Ra definierten Außenrand 25 der Haltefläche 23 und der Außenumfangsfläche 24 ist insbesondere durch eine beispielsweise nach Art einer Anfasung gestaltete konische Übergangsfläche 26 oder durch eine gepunktet angedeutete, im Querschnitt gewölbte Übergangsfläche 27 definiert.

Die oben schon erwähnten, im Bereich der Arbeitsseite 8 angeordneten Abstandshaltemittel 14 haben den Zweck, eine unmittelbare Anlage eines Gegenstandes 2 an der Haltefläche 23 zu verhindern, den Gegenstand 2 also auf Abstand zu der Haltefläche 23 zu halten.

Die Abstandshaltemittel 14 definieren in diesem Zusammenhang eine strichpunktiert angedeutete Gegenstands-Abstützebene 28, die sich rechtwinkelig zu der Hauptachse 7 erstreckt und die der Haltefläche 23 mit einem im Folgenden als "Spalthöhe" bezeichneten Abstand "h" vorgelagert ist.

Wenn ein Gegenstand 2 - wie bei den Ausführungsbeispielen illustriert - mit einer ebenen Gegenstandsfläche 32 an den Abstandshaltemitteln 14 anliegt, fällt die vorgenannte Gegenstandsfläche 32 mit der Gegenstands-Abstützebene 28 zusammen, so dass zwischen der Haltefläche 23 und dem Gegenstand 2 ein ringförmiger Haltespalt 3 ausgebildet ist, der die Spalthöhe "h" aufweist.

Bevorzugt bestehen die Abstandshaltemittel 14 aus einer Mehrzahl von an der Arbeitsseite 8 an dem Kopfkörper 13 verteilt angeordneten Abstandshaltevorsprüngen 33. Es liegt insbesondere eine punktuelle Verteilung vor. Jeder Abstandshaltevorsprung 33 weist an der vom Kopfkörper 13 in der Hauptrichtung abgewandten Seite eine individuelle Abstützfläche 34 auf, an der der Gegenstand 2 anlegbar ist, so dass er eine Abstützung erfährt. Alle Abstützflächen 34 der Abstandshaltemittel 14 liegen in der Gegenstands-Abstützebene 28.

Vorzugsweise ist eine Mehrzahl von Abstandshaltevorsprüngen 33 an der Haltefläche 23 angeordnet. Wie in Figur 3 illustriert ist, sind diese im Folgenden auch als äußere Abstandshaltevorsprünge 33a bezeichneten Abstandshaltevorsprünge 33 um die Hauptachse 7 herum mit Abstand zueinander verteilt und insbesondere auf einem gleichen Kreisdurchmesser liegend an der Haltefläche 23 angeordnet.

Vorzugsweise ist mindestens ein weiterer Abstandshaltevorsprung 33, der im Folgenden auch als innerer Abstandshaltevorsprung 33b bezeichnet ist, radial innerhalb des Kreises von äußeren Abstandshaltevorsprüngen 33a angeordnet und befindet sich insbesondere mittig an der Arbeitsseite 8 und folglich im Zentrumspunkt der ringförmigen Haltefläche 23.

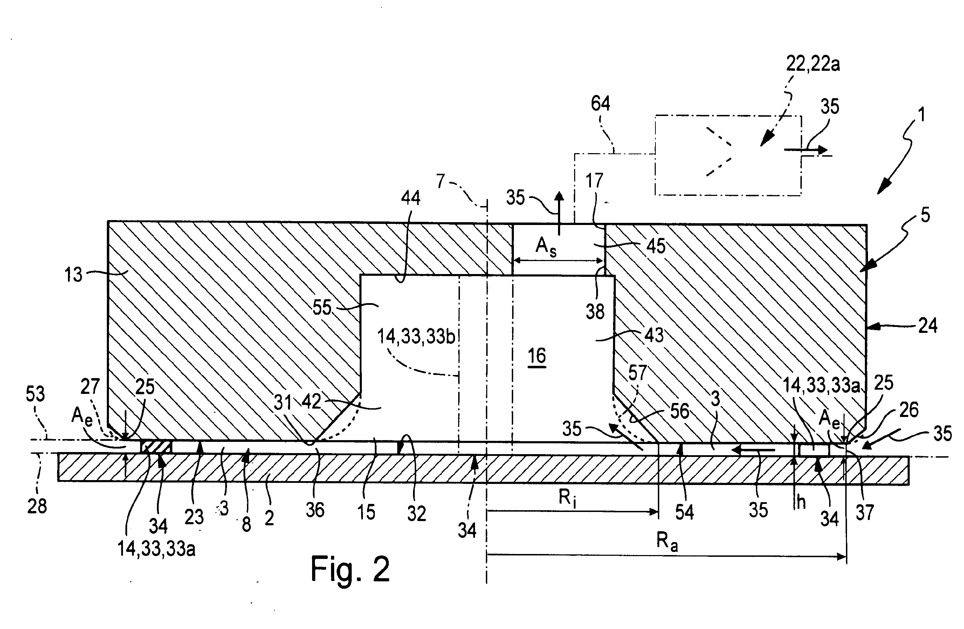

Beim Ausführungsbeispiel der Figur 2 ist der innere Abstandshaltevorsprung 33b nur strichpunktiert angedeutet.

Die Anzahl und Verteilung der Abstandshaltevorsprünge 33 ist prinzipiell beliebig und orientiert sich insbesondere an der Struktur der festzuhaltenden Gegenstände. Wenn keine besonderen Ansprüche an die Stabilität der Relativlage zwischen dem Gegenstand 2 und dem Haltekopf 5 gestellt werden, können die Abstandshaltemittel 14 auch gänzlich entfallen, wobei sich die Spalthöhe "h", also der Abstand zwischen dem Gegenstand 2 und der Haltefläche 23, dann aufgrund der Strömungsdynamik der im Haltespalt 3 strömenden Luft selbsttätig einstellt.

Ein mittels der Haltevorrichtung 1 festzuhaltender Gegenstand 2 wird mit seiner Gegenstandsfläche 32 voraus bis zur Anlage an den Abstützflächen 34 der Abstandshaltemittel 14 an die Arbeitsseite 8 des Haltekopfes 5 angenähert. Dieser Annäherungsvorgang kann auch aktiv durch den Haltekopf 5 relativ zum ortsfest verbleibenden Gegenstand 2 stattfinden. Um den Gegenstand 2 am Haltekopf 5 zu fixieren, wird durch Betätigung der Unterdruckerzeugungseinrichtung 22 an der Anschlussöffnung 17 des Absaughohlraumes 16 ein Unterdruck erzeugt. Dieser Unterdruck ruft eine durch Pfeile 35 illustrierte Absaugströmung hervor, im Rahmen derer Umgebungsluft von radial außen her durch den radial außen umfangsseitig offenen, zwischen dem Gegenstand 2 und der Haltefläche 23 ausgebildeten Haltespalt 3 hindurch zu der zentralen Absaugöffnung 15 und von dort aus, durch den Absaughohlraum 16 hindurch, zur Anschlussöffnung 17 strömt. Diese kontinuierliche Luftströmung bildet sich im gesamten Haltespalt 3 aus, also konzentrisch rings um die Hauptachse 7 herum, mit bezüglich der Hauptachse 7 im Wesentlichen radialer Orientierung.

Aufgrund der verhältnismäßig geringen Spalthöhe "h" wird die angesaugte Umgebungsluft beim Hindurchströmen durch den Haltespalt 3 sehr stark beschleunigt. Dies führt innerhalb des Haltespaltes 3, und vor allem zunehmend in Richtung zu dem dem Innenrand 31 der Haltefläche 23 zugeordneten inneren Spaltendbereich 36, aufgrund des Bernoulli-Effektes bzw. nach der Bernoulli-Gleichung zu einer erheblichen Absenkung des statischen Druckes mit der Folge, dass der Gegenstand 2 "angesaugt" und festgehalten wird. Der Gegenstand 2 wird an die Abstandshaltemittel 14 angedrückt und aufgrund der hierbei zwischen ihm und den Abschlussflächen 34 wirksamen Reibung auch quer zu der Hauptachse 7 reibschlüssig fixiert.

Zwar bildet sich auch im Bereich der Absaugöffnung 15 aufgrund des mit Unterdruck beaufschlagten Absaughohlraumes 16 ein Unterdruck bezüglich des atmosphärischen Umgebungsdruckes aus. Dieser Unterdruck ist jedoch beim Ausführungsbeispiel für die Erzeugung der auf den Gegenstand 2 einwirkenden Haltekraft nur von untergeordneter Bedeutung. Maßgeblich verantwortlich für die auf Unterdruck basierende und auf den Gegenstand 2 einwirkende Haltekraft ist hier der sich in dem Haltespalt 3 aufgrund des Bernoulli-Effektes relativ zur Atmosphäre ausbildende relativ hohe Unterdruck, der eine den Gegenstand 2 in Richtung der Arbeitsseite 8 pressende Unterdruck-Haltekraft hervorruft. Der zumindest überwiegende Anteil der erzeugten Haltekraft basiert hier also auf dem Unterdruck, der durch die durch den Haltespalt 3 hindurchgesaugte Umgebungsluft erzeugt wird.

Bei einer nicht dargestellten Ausführungsform der Haltevorrichtung 1 ist die konstruktive Auslegung so vorgenommen, dass der sich in dem Haltespalt 3 aufgrund des Bernoulli-Effektes relativ zur Atmosphäre ausbildende Unterdruck zwar zum Hervorrufen der den Gegenstand 2 festhaltenden Haltekraft beiträgt, jedoch nicht maßgeblich dafür verantwortlich ist, weil ein sich im Bereich der Absaugöffnung 15 aufgrund des mit Unterdruck beaufschlagten Absaughohlraumes 16 ausbildender Unterdruck ebenfalls in relevanter und unter Umständen sogar in überwiegender Weise für die Erzeugung einer den Gegenstand festhaltenden Haltekraft verantwortlich ist. Bevorzugt wird jedoch eine Auslegung, bei der - wie beim Ausführungsbeispiel - der im Haltespalt 3 aufgrund des Bernoulli-Effektes erzeugte Unterdruck den überwiegenden Anteil an der Haltekraft liefert.

Es hat sich als vorteilhaft erwiesen, den Haltekopf 5 geometrisch und strömungsmechanisch so auszulegen, dass die Spalthöhe "h" des Haltespaltes 3 zwischen - je einschließlich - 0,05 mm und 0,2 mm liegt. Als besonders effektiv hat sich eine Spalthöhe "h" erwiesen, die - je einschließlich - zwischen 0,07 mm und 0,15 mm beträgt.

Die angestrebte Spalthöhe "h" lässt sich sehr einfach durch eine entsprechende Ausgestaltung der Abstandshaltemittel 14 vorgeben. Es ist lediglich der Überstand der Abstandshaltemittel 14 bezüglich der Haltefläche 23 so vorzugeben, dass der Abstand zwischen der Gegenstands-Abstützebene 28 und der Haltefläche 23 der gewünschten Spalthöhe "h" entspricht.

Dadurch, dass sich die Haltefläche 23 insgesamt quer zu der Hauptachse 7 erstreckt, kann in vorteilhafter Weise erreicht werden, dass die Spalthöhe "h" über die gesamte Ausdehnung des Haltespaltes 3 hinweg zumindest im Wesentlichen konstant ist.

Es hat sich weiterhin als vorteilhaft erwiesen, wenn das Radienverhältnis (Ra / Ri), also der Quotient aus dem Außenradius Ra und dem Innenradius Ri, in einem Bereich zwischen - je einschließlich - 0,3 und 0,8 liegt. Besonders empfehlenswert ist hierbei ein Radienverhältnis im Bereich zwischen - je einschließlich - 0,5 und 0,7.

Besonders vorteilhaft ist es, wenn das vorgenannte Radienverhältnis in Kombination mit der weiter oben geschilderten vorteilhaften Spalthöhe "h" realisiert ist.

Der Absaughohlraum 16 stellt der aus der Umgebung abgesaugten Luft für ihr Hindurchströmen einen gewissen Strömungsquerschnitt zur Verfügung. Dieser Strömungsquerschnitt sollte an der engsten Stelle nicht zu klein sein im Verhältnis zu demjenigen Strömungsquerschnitt, der der Luft am äußeren Spaltendbereich 37 des Haltespaltes 3 für ihr Zuströmen in den Haltespalt 3 zur Verfügung gestellt wird. Der äußere Spaltendbereich 37 befindet sich beim Außenrand 25 der Haltefläche 23.

Der maximal mögliche Durchfluss durch den Absaughohlraum 16 wird durch eine minimale Absaugquerschnittsfläche "As" im Innern des Absaughohlraumes 16 definiert, die sich in einem beliebigen Bereich befinden kann, welcher im Folgenden als wirksamer Absaugquerschnittsbereich 38 bezeichnet wird. Gestaltung und Platzierung des wirksamen Absaugquerschnittsbereiches 38 hängen von der Ausgestaltung des Absaughohlraumes 16 ab.

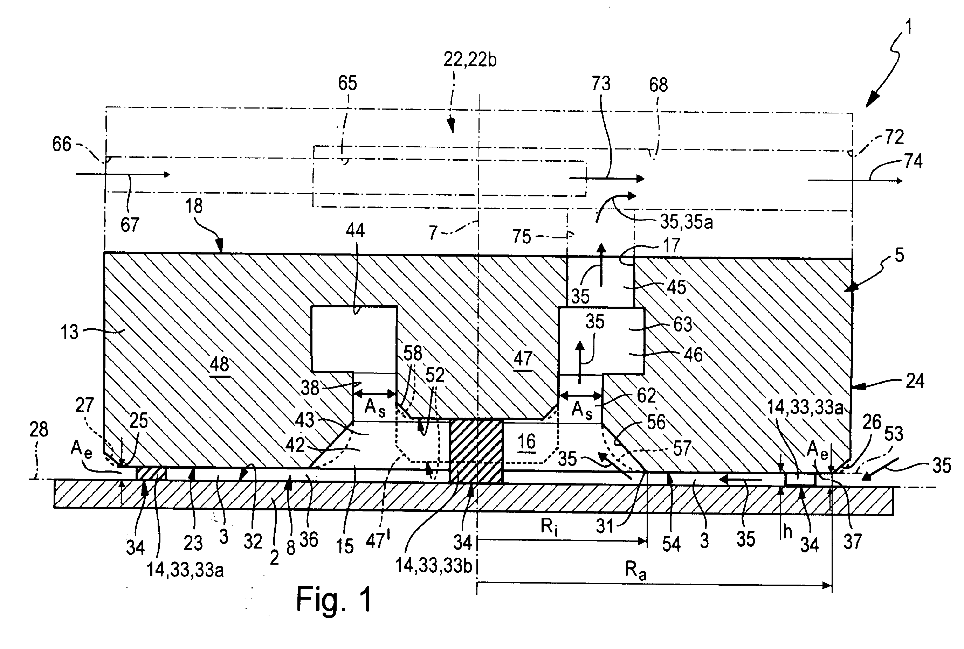

Bei beiden Ausführungsbeispielen ist der Absaughohlraum 16 so gestaltet, dass er einen sich im Innern des Kopfkörpers 13 an die Absaugöffnung 15 anschließenden Eintrittsabschnitt 42 aufweist, der einen kreisförmigen Querschnitt quer zu der Hauptachse 7 aufweist. Eine hiervon abweichende Gestaltung kann sich ergeben, wenn der Eintrittsabschnitt 42, wie dies in Figuren 1 und 2 illustriert ist, von einem Abstandshaltevorsprung 33 durchsetzt wird. Ein solcher Abstandshaltevorsprung 33 kann als innerer Abstandshaltevorsprung 33b insbesondere zentral in dem Eintrittsabschnitt 42 angeordnet sein, so dass selbiger eine ringförmige Querschnittskontur aufweist.

Der Eintrittsabschnitt 42 ist zweckmäßigerweise ein Bestandteil einer insgesamt mit Bezugsziffer 43 bezeichneten und in dem Kopfkörper 13 ausgebildeten Absaugkammer 43, die den Absaughohlraum 16 in seiner Gesamtheit bildet oder, wie beim Ausführungsbeispiel, lediglich einen Teilbereich des Absaughohlraumes 16 definiert. Die Absaugkammer 43 mündet zu der die Haltefläche 23 aufweisenden Arbeitsseite des Kopfkörpers 13 hin mit der Absaugöffnung 15 aus und erstreckt sich ausgehend von der Absaugöffnung 15 in der Hauptrichtung axial in den Kopfkörper 13 hinein.

Beiden Ausführungsbeispielen ist gemeinsam, dass die Absaugkammer 43 an ihrem der Absaugöffnung 15 entgegengesetzten inneren Endbereich 44 sacklochartig im Innern des Kopfkörpers 13 endet und sich der Absaughohlraum 16 im Anschluss an die Absaugkammer 43 mit mindestens einem den Kopfkörper 13 weiter durchsetzenden Absaugkanal 45 fortsetzt. Exemplarisch mündet dieser mindestens eine und zweckmäßigerweise genau eine Absaugkanal 45 zu der Rückseite 18 aus, und zwar mit der schon erwähnten Anschlussöffnung 17. Bei einer nicht gezeigten Variante mündet der Absaugkanal 45 zusätzlich oder alternativ zu der Außenumfangsfläche 24 des Kopfkörpers 13 hin aus.

Es ist nun beispielsweise möglich, die Absaugkammer 43 über ihre gesamte Länge hinweg mit einem kreisförmigen Querschnitt zu versehen, wie dies beim Ausführungsbeispiel der Figur 2 der Fall ist. Hier ergibt sich dann in der Regel eine Konstellation, bei der der Querschnitt der Absaugkammer 43 größer und insbesondere wesentlich größer ist als der Querschnitt des Absaugkanals 45. Dies bedeutet, dass der wirksame Absaugquerschnittsbereich 38, an dem sich die minimale Absaugquerschnittsfläche "As" befindet, durch den Absaugkanal 45 definiert wird.

Eine andere, in Figur 1 illustrierte Ausführungsform sieht vor, dass die Absaugkammer 43 über zumindest einen Teil ihrer in der Achsrichtung der Hauptachse 7 gemessenen Länge ringförmig ausgebildet ist, also über einen ringförmigen Querschnitt verfügt. Dieser Bereich ringförmigen Querschnittes sei im Folgenden als Ringabschnitt 46 der Absaugkammer 43 bezeichnet.

Eine derart gestaltete Kontur der Absaugkammer 43 ergibt sich beispielsweise dadurch, dass der Kopfkörper 13 einen zentralen Kernabschnitt 47 aufweist, der mit radialem Abstand konzentrisch von einem Hüllabschnitt 48 umgeben ist, wobei der ringförmige Zwischenraum zwischen dem Kernabschnitt 47 und dem Hüllabschnitt 48 den Ringabschnitt 46 definiert.

Der Kernabschnitt 47 und der Hüllabschnitt 48 können separate Bauteile sein. Insbesondere kann der Kernabschnitt 47 eine in Achsrichtung der Hauptachse 7 verstellbar an dem Hüllabschnitt 48 fixierte Komponente des Kopfkörpers 13 sein. Bevorzugt wird allerdings eine Variante, bei der gemäß Figur 1 der Kernabschnitt 47 und der Hüllabschnitt 48 einstückig miteinander verbunden und Bestandteile eines einstückig ausgebildeten Kopfkörpers 13 sind.

Die axiale Länge des Ringabschnittes 46 hängt von der Länge des Kernabschnitts 47 ab. Beim Ausführungsbeispiel der Figur 1 hat der Kernabschnitt 47 eine zur Arbeitsseite 8 weisende Kernstirnfläche 52, die innerhalb des Kopfkörpers 13 mit relativ großem Abstand vor einer Abschlussebene 53 endet, die in der der Arbeitsseite 8 zugewandten vorderen Stirnfläche 54 des Kopfkörpers 13 verläuft, die vorzugsweise unmittelbar die Haltefläche 23 definiert.

Strichpunktiert bei 47' ist allerdings angedeutet, dass auch eine andere Längenabmessung des Kernabschnittes 47 möglich ist, beispielsweise derart, dass die Kernstirnfläche 52 mit nur geringem Abstand zu der Abschlussebene 53 im Kopfkörper 13 endet oder gar flächenbündig mit der vorderen Stirnfläche 54 ausgebildet ist. Es ist auch eine Ausgestaltung möglich, bei der der Kernabschnitt 47 unmittelbar einen Bestandteil der Abstandshaltemittel 14 darstellt oder diese Abstandshaltemittel 14 in ihrer Gesamtheit bildet, indem er über die Abschlussebene 53 hinausragend ausgebildet ist.

Gemäß Figur 1 schließt sich der Ringabschnitt 46 zur Rückseite 18 hin an den Eintrittsabschnitt 42 an. Der Eintrittsabschnitt hat hierbei zweckmäßigerweise zumindest bereichsweise einen größeren Außendurchmesser als der Ringabschnitt 46. In diesem Fall ist es von Vorteil, wenn der Eintrittsabschnitt 42 sich ausgehend von der Anschlussöffnung 17 verjüngend in den Ringabschnitt 46 übergeht.

Ein sich verjüngender Übergang des Eintrittsabschnittes 42 in einen sich daran anschließenden und zu dem inneren Endbereich 44 führenden Folgeabschnitt 55 der Absaugkammer 43 kann auch gemäß Figur 2 bei einer Bauform vorgesehen sein, bei der die Absaugkammer 43 nicht durch einen Kernabschnitt 47 definiert ist.

Die sich ins Innere des Kopfkörpers 13 hinein verjüngende Querschnittskontur des Eintrittsabschnittes 42 ist beispielsweise durch eine umfangsseitige Begrenzungsfläche 56 mit konischer Gestaltung realisierbar. Ebenso möglich ist aber beispielsweise auch die gepunktet angedeutete Variante einer umfangsseitigen Begrenzungsfläche 57 mit konvex gewölbter Kontur.

Ein eventuell vorhandener Kernabschnitt 47 kann im Bereich der Kernstirnfläche 52 radial außen ebenfalls abgeschrägt oder abgerundet sein, wie dies bei 58 angedeutet ist.

Bei dem Ausführungsbeispiel der Figur 1 befindet sich der wirksame Absaugquerschnittsbereich 38 in dem Ringabschnitt 46, so dass hier die minimale Absaugquerschnittsfläche As von einer Ringfläche gebildet ist. Vorzugsweise wird der wirksame Absaugquerschnittsbereich 38 von einem sich an den Eintrittsabschnitt 42 anschließenden ersten Ringbereich 62 des Ringabschnittes 46 definiert, an den sich axial zur Rückseite 18 hin ein zweiter Ringbereich 63 größeren Querschnittes anschließt, in den der Absaugkanal 45 einmündet.

Wie sich gezeigt hat, ergibt sich ein sehr gutes Betriebsverhalten der Haltevorrichtung 1 vor allem dann, wenn das Flächenverhältnis zwischen der vom Absaughohlraum 16 zur Verfügung gestellten minimalen Absaugquerschnittsfläche As und der Eintrittsquerschnittsfläche Ae des Haltespaltes 3 größer oder gleich 1 ist. Die Eintrittsquerschnittsfläche Ae ist das Produkt aus 2π, dem Außenradius Ra und der Spalthöhe "h". Eine besonders hohe Haltekraft bei vergleichbar geringem Energieverbrauch ergibt sich dabei, wenn das genannte Flächenverhältnis, je einschließlich, zwischen 3 und 6 liegt.

Eine bestmögliche Effektivität stellt sich dann ein, wenn diese Flächenverhältnisse in Kombination mit dem weiter oben erwähnten Radienverhältnis (Ra / Ri) und der ebenfalls weiter oben genannten optimalen Spalthöhe "h" verwirklicht wird.

Ein zumindest partiell einstückig ausgebildeter Haltekopf 5 lässt sich sehr vorteilhaft im Rahmen eines generativen Fertigungsverfahrens herstellen. Hierbei kommt insbesondere das sogenannte selektive Lasersintern zur Anwendung. Exemplarisch ist der Kopfkörper 13 durch ein solches Verfahren realisiert. Die Abstandshaltemittel 14 sind nachträglich an dem derart gefertigten Kopfkörper 13 fixiert, beispielsweise durch Ankleben. Es ist aber ebenso möglich, die Abstandshaltemittel 14 als einstückigen Bestandteil des Kopfkörpers 13 auszubilden und gleichfalls im Rahmen der generativen Fertigung auszubilden.

Die generative Fertigung ermöglicht es auf einfache und kostengünstige Weise, die strömungsrelevanten Innenkonturen des Absaughohlraumes 16 strömungsgünstig zu gestalten und insbesondere abgerundete Formgebungen vorzusehen, die einen Strömungsabriss und eine Wirbelbildung verhindern.

Wie schon erwähnt, enthält die Haltevorrichtung 1 zweckmäßigerweise eine die Absaugströmung der Umgebungsluft hervorrufende Unterdruckerzeugungseinrichtung 22. Die Figur 1 illustriert, dass eine solche Unterdruckerzeugungseinrichtung 22 als Baueinheit mit dem Haltekopf 5 ausgebildet sein kann, um eine kompakte Baugruppe oder Baueinheit zu erhalten. Illustriert ist eine vorteilhafte Bauweise, bei der die Unterdruckerzeugungseinrichtung 22 an der Rückseite 18 des Haltekopfes 5 angebracht ist. Es besteht aber gleichfalls die vorteilhafte Möglichkeit, die Unterdruckerzeugungseinrichtung 22 unmittelbar in den Haltekopf 5 und insbesondere in den Kopfkörper 13 zu integrieren. Beispielsweise kann der Kopfkörper 13 über ein ausreichendes Volumen verfügen, das es ermöglicht, die funktionsrelevanten Komponenten der Unterdruckerzeugungseinrichtung 22 im Innern des Kopfkörpers 13 unterzubringen. Eine alternative Bauweise ist in Figur 2 illustriert, wobei hier die Unterdruckerzeugungseinrichtung 22 bezüglich des Haltekopfes 5 separat und extern ausgebildet ist und über eine zum Beispiel als Fluidschlauch ausgebildete Fluidleitung 64 an die Anschlussöffnung 17 angeschlossen ist.

Das Funktionsprinzip der Unterdruckerzeugungseinrichtung 22 ist grundsätzlich beliebig. Die Figur 2 zeigt eine Ausführungsform als Vakuumpumpe 22a. Dies empfiehlt sich vor allem bei einer bezüglich des Haltekopfes 5 separaten Anordnung der Unterdruckerzeugungseinrichtung 22.

Insbesondere bei mit dem Haltekopf 5 zu einer Baueinheit zusammengefasster Unterdruckerzeugungseinrichtung 22 empfiehlt sich eine in Figur 1 schematisch angedeutete Realisierung dieser Unterdruckerzeugungseinrichtung 22 in Form einer sogenannten Ejektoreinrichtung 22b. Die Ejektoreinrichtung 22b arbeitet nach dem Prinzip einer Strahldüse und enthält eine Treibdüse 65, die einen Eingangsanschluss 66 aufweist, in den gemäß Pfeil 67 unter Überdruck stehende Druckluft einleitbar ist. Ferner enthält die Ejektoreinrichtung 22b eine sich an die Treibdüse 65 anschließende Fangdüse 68, die über eine Austrittsöffnung 72 zur Umgebung ausmündet. Am Eingangsanschluss 66 eingespeiste Druckluft tritt gemäß Pfeil 73 in die Fangdüse 68 über und tritt im Anschluss daran gemäß Pfeil 74 an der Austrittsöffnung 72 zur Atmosphäre hin aus. Im Übergangsbereich zwischen der Treibdüse 65 und der Fangdüse 68 besitzt die Ejektoreinrichtung 22b einen Absauganschluss 75, der mit der Anschlussöffnung 17 des Absaughohlraumes 16 verbunden oder verbindbar ist und an dem die gemäß Pfeilen 67, 73, 74 durch die Ejektoreinrichtung 22b hindurchströmende Druckluft eine Saugwirkung hervorruft, die den oben schon erwähnten Unterdruck an der Anschlussöffnung 17 und mithin die Absaugströmung 35 erzeugt. Dementsprechend wird die Umgebungsluft gemäß Pfeilen 35 von radial außen her durch den Haltespalt 3 und den Absaughohlraum 16 hindurch abgesaugt und gemeinsam mit der am Eingangsanschluss 66 eingespeisten Druckluft an der Austrittsöffnung 72 wieder zur Atmosphäre ausgeblasen.

Der Luftverbrauch und das Saugvermögen der Haltevorrichtung 1 wird bei dieser Ausgestaltung in vorteilhafter Weise durch den Versorgungsdruck der Ejektoreinrichtung 22b festgelegt, mit dem die Druckluft am Eingangsanschluss 66 eingespeist wird.

Mit der Haltevorrichtung 1 lässt sich durch Saugwirkung eine überaus effiziente Bernoulli-Strömung mit entsprechend hohen Haltekräften bei sehr geringem Luftverbrauch und vergleichsweise ausgeglichener Druckverteilung auf der Haltefläche 23 erzielen. Vor allem auch bei großflächigen Haltezonen wirkt sich dieser Aspekt positiv auf die Entwicklung der Haltekraft in den Außenzonen der Haltefläche 23 aus.

## Patentansprüche

1. Unterdruck-Haltevorrichtung, mit mindestens einem Haltekopf (5), der mindestens eine in einer Hauptrichtung orientierte Arbeitsseite (8) aufweist, an der er aufgrund eines durch Absaugen hervorrufbaren Unterdruckes einen Gegenstand (2) festhalten kann, wobei der Haltekopf (5) an der Arbeitsseite (8) eine Absaugöffnung (15) eines mit einer Unterdruckquelle (22) verbundenen oder verbindbaren Absaughohlraumes (16) aufweist und über eine die Absaugöffnung (15) des Absaughohlraumes (16) umschließende, im Betrieb gemeinsam mit dem festzuhaltenden Gegenstand (2) einen von angesaugter Umgebungsluft durchströmten und eine Spalthöhe (h) aufweisenden Ringspalt definierende ringförmige Stirnfläche verfügt, **dadurch gekennzeichnet, dass** die ringförmige Stirnfläche als Haltefläche (23) ausgebildet ist, so dass der von ihr gemeinsam mit dem festzuhaltenden Gegenstand begrenzte Ringspalt einen ringförmigen Haltespalt (3) bildet, in dem sich aufgrund der von außen nach innen hindurchströmenden Umgebungsluft nach dem Bernoulli-Prinzip ein zum Festhalten des Gegenstandes (2) beitragender Unterdruck einstellt.

2. Unterdruck-Haltevorrichtung nach Anspruch 1, **dadurch gekennzeichnet, dass** sie so ausgelegt ist, dass der sich in dem ringförmigen Haltespalt (3) nach dem Bernoulli-Prinzip ausbildende Unterdruck maßgeblich für das Festhalten des Gegenstandes (2) verantwortlich ist.

3. Unterdruck-Haltevorrichtung nach Anspruch 1 oder 2, **dadurch gekennzeichnet, dass** der Haltekopf (5) im Bereich der Arbeitsseite (8) über Abstandshaltemittel (14) verfügt, die eine Gegenstands-Abstützebene (28) zur Abstützung des festzuhaltenden Gegenstandes (2) definieren, die der ringförmigen Haltefläche (23) zur Vorgabe des Haltespaltes (3) mit Abstand vorgelagert ist.

4. Unterdruck-Haltevorrichtung nach einem der Ansprüche 1 bis 3, **dadurch gekennzeichnet, dass** die Spalthöhe (h) des Haltespaltes (3) zwischen, je einschließlich, 0,05 mm und 0,2 mm liegt und vorzugsweise zwischen, je einschließlich, 0,07 mm und 0,15 mm.

5. Unterdruck-Haltevorrichtung nach einem der Ansprüche 1 bis 4, **dadurch gekennzeichnet, dass** die Spalthöhe (h) des Haltespaltes (3) über die gesamte Ausdehnung des Haltespaltes (3) hinweg zumindest im Wesentlichen konstant ist.

6. Unterdruck-Haltevorrichtung nach einem der Ansprüche 1 bis 5, **dadurch gekennzeichnet, dass** die ringförmige Haltefläche (23) einen Außenradius (Ra) und einen Innenradius (Ri) aufweist, wobei das Radienverhältnis (Ra/ Ri) zwischen dem Außenradius (Ra) und dem Innenradius (Ri) zwischen, je einschließlich, 0,3 und 0,8 liegt und vorzugsweise zwischen, je einschließlich, 0,5 und 0,7 liegt.

7. Unterdruck-Haltevorrichtung nach einem der Ansprüche 1 bis 6, **dadurch gekennzeichnet, dass** eine minimale Absaugquerschnittsfläche (As) des von der angesaugten Umgebungsluft durchströmten Absaughohlraumes (16) mindestens so groß ist wie die von dem Haltespalt (3) im Bereich des Außenradius (Ra) der Haltefläche (23) definierte Eintrittsquerschnittsfläche (Ae).

8. Unterdruck-Haltevorrichtung nach Anspruch 7, **dadurch gekennzeichnet, dass** die minimale Absaugquerschnittsfläche (As) des Absaughohlraumes (16) mindestens doppelt so groß ist wie die Eintrittsquerschnittsfläche (Ae) des Haltespaltes (3) und zweckmäßigerweise, je einschließlich, das Dreifache bis Sechsfache der Eintrittsquerschnittsfläche (Ae) des Haltespaltes (3) beträgt.

9. Unterdruck-Haltevorrichtung nach einem der Ansprüche 1 bis 8, **dadurch gekennzeichnet, dass** der Absaughohlraum (16) eine zu der Arbeitsseite (8) hin offene Absaugkammer (43) und einen zur Verbindung der Absaugkammer (43) mit einer Unterdruckquelle (22) dienenden Absaugkanal (45) aufweist.

10. Unterdruck-Haltevorrichtung nach Anspruch 9, **dadurch gekennzeichnet, dass** die Absaugkammer (43) zumindest über einen Teil ihrer in der Hauptrichtung gemessenen Länge hinweg ringförmig ausgebildet ist.

11. Unterdruck-Haltevorrichtung nach einem der Ansprüche 1 bis 10, **dadurch gekennzeichnet, dass** sie eine an den Absaughohlraum (16) angeschlossene oder anschließbare Unterdruckerzeugungseinrichtung (22) enthält, die zweckmäßigerweise als Ejektoreinrichtung (22b) ausgebildet ist.

12. Unterdruck-Haltevorrichtung nach Anspruch 11, **dadurch gekennzeichnet, dass** die Unterdruckerzeugungsvorrichtung (22) als Baueinheit mit dem Haltekopf (5) oder als bezüglich des Haltekopfes gesonderte, individuelle Komponente ausgebildet ist.

13. Unterdruck-Haltevorrichtung nach einem der Ansprüche 1 bis 12, **dadurch gekennzeichnet, dass** der Haltekopf (5) einen die Haltefläche (23) und den Absaughohlraum (16) aufweisenden, vorzugsweise einstückig ausgebildeten Kopfkörper (13) aufweist, an dem zweckmäßigerweise Abstandshaltemittel (14) angeordnet sind, die die Spalthöhe (h) des zwischen dem festzuhaltenden Gegenstand (2) und der Haltefläche (23) gewünschten Haltespaltes (3) vorgeben.

14. Unterdruck-Haltevorrichtung nach Anspruch 13, **dadurch gekennzeichnet, dass** die Unterdruckerzeugungseinrichtung (22) an dem Kopfkörper (13) angeordnet oder in den Kopfkörper (13) unmittelbar integriert ist.

15. Unterdruck-Haltevorrichtung nach einem der Ansprüche 1 bis 14, **dadurch gekennzeichnet, dass** der Haltekopf (5) zumindest partiell ein durch Anwendung eines generativen Fertigungsverfahrens hergestelltes einstückiges Bauteil ist.

16. Unterdruck-Haltevorrichtung nach einem der Ansprüche 1 bis 15, **dadurch gekennzeichnet, dass** sie als Greifvorrichtung zum Ergreifen und Umpositionieren eines ergriffenen Gegenstandes (2) ausgebildet ist.
